# EUROPÄISCHE PATENTSCHRIFT

(11) **EP 1 149 358 B1**
(45) Veröffentlichungstag und Bekanntmachung des Hinweises auf die Patenterteilung: **29.10.2003**
(21) Anmeldenummer: 00901503.3
(22) Anmeldetag: 03.01.2000
(51) Int. Cl.: G06K 19/073

(54) **KONTAKTLOSE CHIPKARTE**
CONTACTLESS CHIP CARD
CARTE A PUCE SANS CONTACT

(30) Priorität: 29.01.1999 EP 99101576
(43) Veröffentlichungstag der Anmeldung: 31.10.2001
(73) Patentinhaber: Infineon Technologies AG, 81669 München (DE)
(72) Erfinder: SMOLA, Michael, D-80636 München (DE); WEGERTSEDER, Dominik, D-85540 Haar (DE)
(74) Vertreter: Epping Hermann & Fischer
(86) Internationale Anmeldenummer: EP0000025
(87) Internationale Veröffentlichungsnummer: WO00045332

(56) Entgegenhaltungen:
- DE-A- 4 018 688
- US-A- 5 060 261
- US-A- 5 233 505

## Beschreibung

Es sind Chipkarten bekannt, welche eine integrierte Schaltung aufweisen und welche mit einer an der Chipkarte angebrachten Antenne versehen sind. Mittels dieser Antenne ist eine kontaktlose Übertragung von Daten oder Energie auf die integrierte Schaltung der Chipkarte möglich. Dabei ist die Antenne als senkundäre Spule eines Übertragers ausgebildet, wodurch bei ausreichender Annäherung der Chipkarte an eine primäre Spule in einem Terminal eine Spannung in der Antenne erzeugbar ist und dadurch die integrierte Schaltung mit Energie versorgt werden kann. Zusätzlich können Daten in die oder aus der Chipkarte heraus an die externe primäre Spule im Terminal übertragen werden. Diese Chipkarten erweisen sich als sehr anfällig gegen Fremdanalysen oder auch gegen Manipulationen. Sie sind auch sehr anfälllig gegen mechanische Belastungen und teuer.

Es sind elektronische Schaltungen bekannt, die sicherheitsrelevante Informationen enthalten und durch spezielle Schutzschaltungen vor Fremdanalyse oder auch vor Manipulation geschützt werden. Um einen solchen Schutz zu erreichen, wurden verschiedene Wege beschrieben. Beispielsweise wurden zu schützende, integrierte Schaltkreise mit einer metallischen Hülle beispielsweise aus Silber oder Titan versehen, wodurch ein Auslesen des integrierten Schaltkreises mittels Röntgenstrahlen verhindert werden kann. Weiterhin hat sich bewährt, in der obersten Schaltungsebene einer integrierten Schaltung eine Leiterbahn als Schutzschildleitung anzuordnen und deren physikalische Eigenschaften, wie der Widerstand, der Kapazität, etc. zu überwachen. Bei der Feststellung einer Veränderung, beispielsweise durch Kurzschließen, Erden oder Durchtrennen beim unerwünschten Beobachten oder Manipulieren wird ein Alarmsignal ausgelöst. Anhand dieses Alarmsignals wird die integrierte Schaltung in einen Zustand überführt, der als Sicherheitsmodus bezeichnet wird. In diesem Sicherheitsmodus lassen sich beispielsweise die Inhalte der Speicherzellen nicht mehr auslesen, da sie beispielsweise unmittelbar nach dem Übergang in den Sicherheitsmodus vollständig gelöscht und somit die darin enthaltenen Informationen unwiederbringlich verloren gegangen sind. Damit ist es nicht mehr möglich, die in dem Programm- und in den Datenspeichern enthaltenen wichtigen Informationen der integrierten Schaltung, beispielsweise Codeschlüssel oder Pinnummern oder persönliche Daten des Benutzers auszulesen oder zu manipulieren. Derartige Schutzschaltungen erweisen sich als schaltungstechnisch sehr aufwendig und sehr teuer, da sie merklich vergrößerte Chipflächen erforderlich machen.

Aus der DE 40 18 688 A ist eine integrierte Schaltung mit einer Schutzschaltung und einer Antenne zur Übertragung von Daten oder Energie bekannt. Zum Schutz der integrierten Schaltung ist eine zusätzliche Schutzschicht in einer weiteren Metallisierungsebene der integrierten Schaltung vorgesehen, die zu schützende Teile vollständig mit Metall überdeckt. Mit Hilfe der Schutzschaltung wird detektiert, ob die Schutzschicht durch einen Angriff beschädigt wurde.

Ebenso sind aus der US-A-5,233,505 und der US-A-5,060,261 integrierte Schaltungen bekannt, die separate Schutzschichten zum Schutz von bestimmten Schaltungsteilen besitzen.

Bei diesen drei bekannten Anordnungen handelt es sich um eine zusätzliche Schicht, die eine weitere Metallisierungsebene erforderlich macht und daher teuer in der Realisierung ist.

Der Erfindung liegt die Aufgabe zugrunde, eine integrierte Schaltung mit einer Antenne zur kontaktlosen Übertragung von Daten oder Energie anzugeben, die die vorgenannten Nachteile möglichst überwindet.

Diese Aufgabe wird erfindungsgemäß durch eine integrierte Schaltung mit den in Anspruch 1 angegebenen Merkmalen gelöst.

Vorteilhafte Weiterbildungen der Erfindung sind Gegenstand der Unteransprüche.

Die Erfindung zeigt eine integrierte Schaltung, deren Antenne zur kontaktlosen Übertragung von Daten oder Energie als Teil der integrierten Schaltung realisiert ist und somit im Rahmen des Herstellungsprozesses der integrierten Schaltung ausgebildet wird. Dadurch ist es möglich, auf eine Vielzahl von elektrischen Kontakten zwischen der Antenne und der Empfängerschaltung zu verzichten und zudem die Länge der Übertragungswege von der Antenne zur Empfängerschaltung wie auch zur Antenne zu reduzieren, was die Verluste an Signalstärke auf dem Übertragungsweg merklich reduziert. Hierdurch wird es möglich, die Antenne bzw. den Emfpänger für das übertragene Signal oder den Sender für das zu übertragende Signal einfacher und von der Diesize kleiner auszubilden, was die integrierte Schaltung kostengünstiger macht. Weiterhin erweist sich die integrierte Schaltung mit Antenne als gegen mechanische Belastungen weniger anfällig, da nun eine mechanische Schädigung der Verbindungleitungen oder der Antenne wie bei den Schaltungen mit externer Antenne entsprechend dem Stand der Technik durch Verbiegen der Chipkarte hervorgerufenes Abbrechen der elektrischen Verbindungsleitungen zwischen Antenne und integrierter Schaltung ausgeschlossen ist. Damit erweist sich die erfindungsgemäße integrierte Schaltung mit Antenne als wenig anfällig.

Erfindungsgemäß wird die in der Schaltung integrierte Antenne nicht nur als Sende- oder Empfangsantenne verwandt, sondern darüberhinaus auch als Schutzschild verwendt, welcher oberhalb und/oder unterhalb der zu schützenden Schaltungsteile der integrierten Schaltung angeordnet ist. Dies wird dadurch erreicht, dass die Antenne in einer Schaltungsebene angeordnet ist, die oberhalb und/oder unterhalb der Schaltungsebene für die zu schützende Schaltung oder die zu schützenden Schaltungsteile angeordnet ist. Als Teil der Schutzschaltung wird die Antenne mit Schutzschaltungssignalen beaufschlagt. Diese Signale werden über die Leiterbahn/en der Antenne übertragen und anschließend untersucht. Werden im Rahmen der Untersuchung signifikante Abweichungen festgestellt, so wird ein Alarmsignal ausgelöst, das die integrierte Schaltung in einen Sicherheitsmodus überführt. Diese Abweichungen können dadurch verursacht werden, dass die Leiterbahnen der Antenne kurzgeschlossen, unterbrochen oder in ihren physikalischen Eigenschaften beispielsweise im Widerstand, in der Kapazität oder ähnliches so verändert werden, dass diese Veränderung als Eingriff beispielsweise durch mechanisches Abtragen einzelner Schichten der integrierten Schaltung, oder durch Durchbohren des Schutzschildes oder durch Kontaktieren der Leiterbahnen der Antenne erkannt werden.

Durch diese mehrfache Funktion der Antenne einerseits als Sende- und Empfangselement für die Übertragung von Daten oder Energie und zum anderen als Schutzschild der Schutzschaltung gelingt es wiederum, die für die Realisierung der geschützten, integrierten Schaltung mit Antenne erforderliche Chipfläche weiter zu reduzieren, da eine integrative Nutzung der Antenne gegeben ist und darüberhinaus die erforderlichen Zuleitungen und Ableitungen der Antenne und der Schutzschaltung sowie deren Vorkehrungen zur Entkopplung der Leitungen vereinfacht oder verringert werden können.

Dabei kann der Schutzschild sowohl von einer einzigen Antenne wie auch von mehreren voneinander getrennten Antennen realisiert sein. Durch eine derartige mehrfache Ausbildung der Antennen ist es möglich, nicht nur differenzierte Signale zu übertragen, sondern auch räumlich differenziert je nach Lage der einzelnen Antennen einen Angriff auf einen bestimmten zu schützenden Schaltungsteil zu detektieren und dadurch gezielt differenzierte Maßnahmen zum Schutz des betreffenden Schaltungsteiles oder auch darüberhinausgehende Schaltungsteile zu ergreifen.

Vorzugsweise zeigt die Erfindung ein oder mehrere Selektionselemente, welche der Antenne zugeordnet sind und die die Funktion der Antenne als Teil der Schutzschaltung oder als Mittel zur Übertragung von Daten oder Energie festlegen. Diese Funktionszuordnung kann so erfolgen, dass zu einem Zeitpunkt entweder die Schutzfunktion oder die Übertragungsfunktion vorliegt, während zu einem anderen, späteren Zeitpunkt die andere Funktionalität gegeben ist. Diese beiden Funktionen werden alternierend mittels der Selektionselemente festgelegt. Diese alternierende Festlegung kann in einem festen, insbesondere gleichmäßigen zeitlichen Raster folgen, was die Signalauswertung der Schutzschaltungssignale wesentlich erleichtert. Die Funktionszuordnung der Antenne erfolgt in der Art eines Zeitmultiplexbetriebes.

Daneben ist es auch möglich, die Antenne mit einem Signal zu beaufschlagen, welches einerseits die Übertragung der von der integrieten Schaltung zu sendenden Daten ermöglicht und zum anderen geeignet ist, als Schutzschaltungssignal verwendet zu werden. Ein solches Signal ist regelmäßig dann für eine solche Anwendung geeignet, wenn es voneinander trennbare Schutzschaltungssignale und Sende- und/oder Empfangssignale enthält. Die Trennung oder die Zusammenfügung wird durch die Selektionsmittel vorgenommen, welche im Fall der Trennung beispielsweise als ein Frequenzfilter mit Hochpass- oder Tiefpasscharakteristik oder auch Bandpasscharakteristik oder als Demodulator ausgebildet sein können. Im Falle von überlagerten Signalen unterschiedlicher Frequenzlage kann die Trennung durch geeignete Wahl von Filtern vorgenommen werden. Entsprechend ist es auch möglich, dass durch die Verwendung eines geeigneten Demodulators ein auf einem Signal aufmoduliertes zweites Signal herausgelöst wird und vom ersten Signal getrennt ausgewertet wird. In diesem Fall wird das verbundene, gemeinsame Signal gemeinsam über die Leiterbahnen der Antenne übertragen. In diesem Falle wird die Antenne also zeitgleich als Übertragungsmittel für Daten und/oder Energie wie auch als Teil der Schutzschaltung für die integrierte Schaltung verwendet. Durch diese zeitgleiche Funktionalität ist sichergestellt, dass zu jedem beliebigen Zeitpunkt eine Erfassung eines Angriffs auf die integrierte Schaltung mit den geschützten Schaltungsteilen erkannt wird.

Nach einer bevorzugten Ausführungsform der Erfindung sind die Antenne und damit die Leiterbahnen der Antenne so ausgebildet, dass sie die zu schützende integrierte Schaltung oder deren Schaltungsteile weitgehend, idealerweise vollständig, flächig so bedecken, dass in ihrer Durchsicht durch die Antenne auf die zu schützende Schaltungsteile keine Möglichkeit mehr besteht, die Schutzschaltung beispielsweise durch Bohrungen oder ähnliches direkt zu erreichen, das heißt, ohne die Leiterbahnen der Antenne zu verletzen. Diese weitgehende oder vollständige Bedeckung wird insbesondere durch eine Ausbildung der Leiterbahnen über mehrere Schaltungsebenen oder in mehreren Schaltungsebenen auf einfachem und sicheren Wege ermöglicht, da die Leiterbahnen in einer Ebene mit ausreichendem Abstand zueinander angeordnet sein müssen, um dadurch ein Übersprechen zu verhindern. Der Bereich zwischen den Leiterbahnen der Antenne in einer Schaltungsebene kann durch Leiterbahnen in anderen Schaltungsebenen gerade abgedeckt werden, so dass eine vollständige Abdeckung der zu schützenden Schaltungsteile möglich ist. Vorzugsweise wird die Antenne mit Leiterbahnen von sehr geringer Leiterbahnbreite ausgebildet, die der Größe einer Bohrung zum Angriff auf die geschützte Schaltung entspricht oder geringer ist. So führt jede Bohrung zu einer Unterbrechung der Leiterbahn und somit zu einem sehr sicher zu detektierenden Fehlsignal. Auch ist es möglich, dass eine derartige Bohrung zu einem Kurzschluss zwischen verschiedenen Leiterbahnen führt, der als totaler Signaleinbruch sehr sicher als Fehlsignal durch die entsprechenden Detektoren erkannt wird. Durch die Ausbildung der Leiterbahnen der Antenne als sehr schmale Leiterbahnen, deren Breiten bevorzugt der bei einer bestimmten verwendeten Chiptechnologie minimalen Leiterbahnbreite entspricht, ist es möglich, eine spulenförmige Antenne mit einer sehr großen Windungszahl zu realisieren. Durch diese hohe Windungszahl ist es möglich, beachtliche Energien über die Antenne zu übertragen. Mithin erweist sich die bevorzugte Ausbildung einer Antenne mit einer sehr großen Anzahl an Windungen als besonders geeignet für eine Schutzschaltung mit besonders feinen Leitbahnen, welche eng zueinander beabstandet sind.

Vorzugsweise werden der oder die zu schützenden Schaltungsteile der integrierten Schaltung sandwichartig vorzugsweise von mehreren Antennen umschlossen, so dass eine Beobachtung oder Manipulation der zwischen den Antennen angeordneten Schaltungsteilen sowohl von oben als auch von unten ausgeschlossen ist. Dabei hat es sich bewährt, die Antenne in der jeweils obersten bzw. untersten Schaltungsebene der integrierten Schaltung vorzugsweise vollflächig auszubilden. Dadurch ist nicht nur eine optimale Übertragung von Daten oder von Energie ermöglicht, da allein durch das Gehäuse der integrierten Schaltung und nicht durch andere Ebenen der integrierten Schaltung eine abschirmende Wirkung gegeben ist, sondern auch einen optimalen Schutz der inneren Schaltungsebenen der integrierten Schaltung erreicht, da nun diese inneren Schaltungsebenen komplett durch die oberste und unterste Schaltungsebene mit den darin angeordneten Antennen bedeckt und dadurch geschützt sind. Mithin kann ein erfolgreicher Angriff nur noch über die Seite der integrierten Schaltung mit den verschiedenen Schaltungsebenen erfolgen.

Es hat sich besonders bewährt, die Antenne oder die Antennen in einer Schaltungsebene schneckenförmig auszubilden, wodurch auf fertigungstechnisch besonders einfache Weise eine Vielzahl von Windungen für die Antenne bzw. die Antennen erzeugt werden können. Diese schneckenförmig ausgebildeten Antennen können als sekundäre Spule eines Übertragers wirken, dessen primäre Spule sich in einem Terminal befindet, das zur Auswertung und Übertragung von Daten einer Chipkarte mit der erfindungsgemäßen integrieten Schaltung geeignet ist. Diese Daten- und Energieübertragung zwischen der primären und sekundären Spule und umgekehrt erfolgt wie bei einem konventionellen Transformator, bei dem ein Wechselspannungssignal von der einen Spule auf die andere Spule übertragen wird und dabei nicht nur die sich verändernden Signale übertragen, sondern auch zusätzlich Energie von der einen Spule zur anderen Spule übertragen wird.

Nach einer bevorzugten Ausführungsform der Erfindung sind die Signalgeneratoren zur Erzeugung eines Schutzschaltungssignales und/oder die Signaldetektoren zur Auswertung des von der Antenne zugeführten Schutzschaltungssignales in einer Schaltungsebene unterhalb der obersten Schaltungsebene mit der Antenne angeordnet und durch deren Leiterbahnen vor einem zu verhindernden Zugriff geschützt. Ebenso sind die Signaldetektoren bzw. die Signalgeneratoren in einer Schaltungsebene oberhalb der untersten Schaltungsebene mit Leiterbahnen der Antenne angeordnet, wodurch eine sandwichartige Struktur gegeben ist, die die Signaldetektoren bzw. die Signalgeneratoren der Schutzschaltung durch die Antennen in den äußersten Schaltungsebenen der integrierten Schaltung schützt und die darüberhinaus die weiteren zu schützenden Schaltungsteile der integrierten Schaltung unter Schutz stellt. Durch diesen systematischen Aufbau ist ein kaskadierender Schutz durch die Leiterbahnen der Antenne oder der Antennen für die Signalgeneratoren bzw. die Signaldetektoren gegeben und durch die Leiterbahn der Antenne mit den Signalgeneratoren und den Signaldetektoren für die restliche integrierte Schaltung gegeben. Durch diese Anordnung ist ein Beobachten oder Manipulieren der Signalgeneratoren oder der Signaldetektoren aufgrund des Schutzes durch die darüberliegenden Leiterbahnen der Antenne oder der Antennen verhindert, was eine weitere Angriffsmöglichkeit ausschließt, in der direkt ohne Umweg über die Leiterbahnen in die Signaldetektoren Signale eingespeist werden. Mithin erweist sich eine derartige Anordnung als besonders geeignetes Mittel, die Schutzwirkung der Schutzschaltung mit der zugeordneten Antenne für die integrierte Schaltung zu erhöhen.

Es hat sich bewährt, die Signaldetektoren so auszubilden, dass die übertragenen Schutzschaltungssignale bei der Auswertung auf deren Integrität untersucht werden, was insbesondere durch einen CRC-Check, durch einen Quersummenvergleich, durch ein Parity-Check oder durch Signaturvergleiche, insbesondere bei digitalen Schutzschaltungssignalen erfolgen kann. Durch diesen Integritätsvergleich zwischen dem über die Antenne übertragenen Schutzschaltungssignal und dem Integritätswert des erwarteten Signales - auch Referenzsignal genannt - ist es möglich, eine Manipulation der Schutzschaltung mit einem reinen Identitätsvergleich zur Feststellung eines Fehlverhaltens auszuschließen, bei der der Signaldetektor quasi kurzgeschlossen wird und ihm ein und dasselbe Signal sowohl als Referenzsignal wie auch als über die Antenne übertragenes Signal im Gegensatz zu einer Schutzschaltung zugeführt wird.

Eine beispielhafte erfindungsgemäße integrierte Schaltung mit wenigstens einer Antenne zur kontaktlosen Übertragung von Daten oder Energie und deren Vorteile werden im Folgenden anhand der Zeichnungen näher erläutert. Es zeigen:
- Fig. 1: ein Schaltungsaufbau einer beispielhaften integrierten Schaltung und
- Fig. 2: eine bevorzugte Antennenausbildung in einer Schaltungsebene.

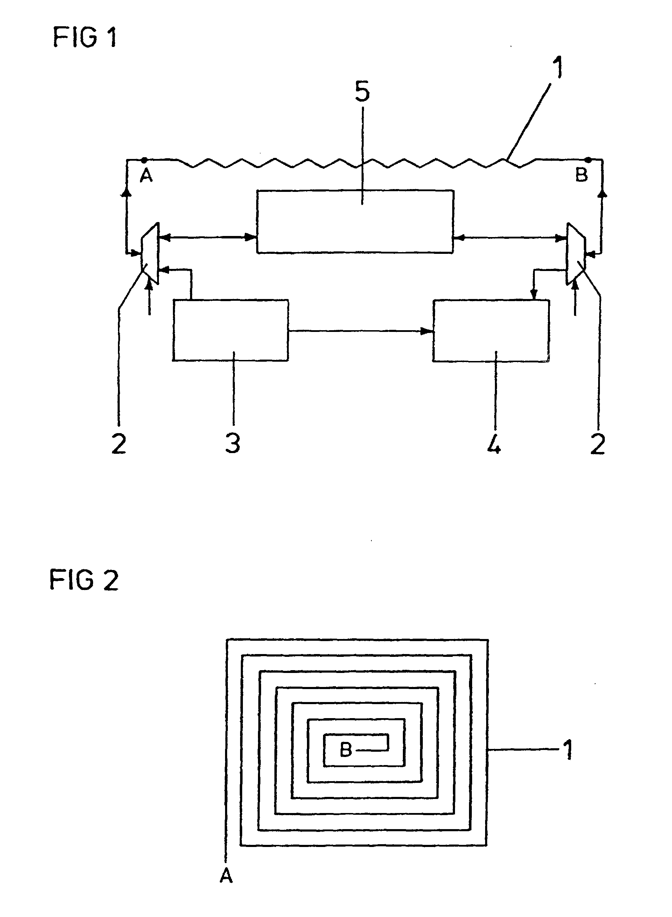

In Fig. 1 ist schematisch ein Aufbau einer erfindungsgemäßen integrierten Schaltung dargestellt. Auf die Darstellung von Schaltungsteilen, welche zu der Funktionalität der Erfindung nicht beitragen, wurde verzichtet.

Die Erfindung zeigt eine Antenne 1, welche sich von Punkt A bis zum Punkt B erstreckt. Der Antenne 1 ist eine Sende-/-Empfangseinheit 5 für die Daten- und Energieübertragung zugeordnet. Diese Übertragung erfolgt als kontaktlose Übertragung mittels der Antenne 1. Sollen Daten von der integrierten Schaltung aus zu einem externen Empfänger übertragen werden, so werden diese Daten in der Sende-/Empfangseinheit 5 generiert und der Antenne 1 über den Punkt A der Antenne 1 zugeführt. In der Antenne 1 wird das zugeführte, zu übertragende Signal ausgesandt und als elektromagnetische Wellen durch eine externe Antenne und einem dieser Antenne zugeordneten Empfänger empfangen, ausgewertet und dargestellt. Sollen Daten durch die integrierte Schaltung empfangen werden, so werden die entsprechenden elektromagnetischen Signale durch die Antenne 1 aufgenommen, in elektrische Signale gewandelt, welche über den Punkt B der Antenne 1 der Sende-/Empfangseinheit 5 zugeführt werden. Hier werden die empfangenen Signale verstärkt, analysiert und der nicht dargestellten weiteren integrierten Schaltung zur Verfügung gestellt. Neben einer Datenübertragung mittels einer Modulation der empfangenen elektromagnetischen Felder ist es auch möglich, der integrierten Schaltung Energie über die Antenne 1 zuzuführen. Diese übertragene Energie wird dazu verwendet, die integrierte Schaltung zu betreiben.

Neben den zu sendenden Daten wird die Antenne 1 auch mit Schutzschaltungssignalen beaufschlagt, welche von einem Signalgenerator 3 erzeugt werden. Diese Schutzschaltungssignale werden der Antenne 1 entsprechend den zu übertragenden Daten über den Punkt A eingespeist und über die Leiterbahn der Antenne 1 zum Punkt B übertragen. Von dort werden die Schutzschaltungssignale einem Signaldetektor 4 zugeführt. Jedes zugeführte Schutzschaltungssignal wird mit einem Referenzsignal verglichen, das von dem Signalgenerator 3 ohne Umweg über die Antenne 1 dem Signaldetektor 4 zugeführt wird. Das Referenzsignal stellt entweder unmittelbar das Signal dar, wie es nach dem Durchlaufen der Antenne 1 zu erwarten ist oder es enthält die notwendigen Informationen, um eine Veränderung des über die Antenne 1 übertragenen Schutzschaltungssignals durch einen unberechtigten Angriff festzustellen. Derartige Informationen können durch Integritätskriterien in Form von Quersummen oder Entsprechendes gebildet sein. Wird in dem Signaldetektor 4 ein signifikanter Unterschied zwischen dem Referenzsignal und dem von der Antenne 1 empfangenen Signal festgestellt, so wird ein Alarmsignal generiert, das als Steuersignal die integrierte Schaltung in einen Sicherheitsmodus überführt. In diesem Sicherheitsmodus lassen sich beispielsweise die Inhalte der Speicherzelle nicht mehr auslesen, da sie vorzugsweise unmittelbar nach dem Übergang in den Sicherheitsmodus vollständig gelöscht werden und somit die darin enthaltenen Informationen unwiederbringlich verloren gegangen sind. Damit ist es nicht mehr möglich, die in den Programm- und Datenspeichern der integrierten Schaltung enthaltenen wichtigen Informationen, beispielsweise Codeschlüssel oder Pinnummern oder persönliche Daten des Benutzers, auszulesen oder zu manipulieren.

Eine solche Veränderung des Schutzschaltungssignals auf dem Übertragungsweg der Antenne 1 wird dadurch bewirkt, wenn von außen eine Manipulation oder Beobachtung der integrierten Schaltung beispielsweise durch schichtweises Abhobeln der Deckflächen, durch Anbohren der Schaltungsebenen oder durch Aufbringen von Kontaktstiften erfolgt. Diese Eingriffe in die integrierte Schaltung mit der Antenne 1 als Teil der Schutzschaltung, welche die zu schützenden Schaltungsteile bedeckt und auf diese Angriffe durch Signalveränderungen reagiert, verhindert auf wirkungsvolle Weise einen Angriff auf die geschützten Schaltungsteile. Die signifikanten Veränderungen der Schutzschaltungssignale werden durch Veränderung der physikalischen Eigenschaften der Antenne 1 bewirkt, welche insbesondere durch Kurzschluss, durch Unterbrechung oder durch Veränderung des Widerstandes oder der Kapazität hervorgerufen werden.

Die Antenne 1 hat somit zwei voneinander getrennte Funktionalitäten. Einerseits wirkt sie als Mittel zur kontaktlosen Übertragung von Daten oder Energie und zum anderen wirkt sie als Teil einer Schutzschaltung, die Teile der integrierten Schaltung auf unerwünschte Angriffe überwacht. Diese zwei Funktionen werden alternierend in der Art eines Zeitmultiplexbetriebes realisiert. Hierfür sind Selektionsmittel 2 vorgesehen, welche auf einer Seite mit der Sende-/Empfangseinheit 5 für die Datenübertragung und dem Signalgenerator 3 bzw. dem Signaldetektor 4 verbunden sind und auf der anderen Seite mit dem Punkt A bzw. dem Punkt B der Antenne 1 verbunden sind. Diese Selektionsmittel 2 sind durch eine nicht dargestellte Steuereinheit so gesteuert, dass sie je nach Funktionsweise zwischen der Sende-/Empfangseinheit 5 und dem Signalgenerator 3 bzw. dem Signaldetektor 4 umschalten. Dadurch ist der Betrieb der Antenne 1 der integrierten Schaltung zu einem durch die Steuereinheit festgelegten Zeitpunkt als Teil der Schutzschaltung möglich, während zu einem anderen festgelegten Zeitpunkt der Betrieb als Antenne für die kontaktlose Übertragung von Daten oder Energie möglich ist. Mithin wird die Antenne je nach Schaltungszustand der Selektionsmittel 2 mit einer unterschiedlichen Funktion betrieben. Damit ist es erfindungsgemäß möglich, auf eine mehrfache Ausbildung der Antenne 1 einmal als Mittel zur Übertragung von Daten oder Energie bzw. als Schutzschild zu verzichten, was sich in einem reduziertem Diesize für die integrierte Schaltung und damit in reduzierten Kosten für die integrierte Schaltung niederschlägt.

In Fig. 2 ist eine bevorzugte Ausbildung der Antenne 1 in einer Schaltungsebene der integrierten Schaltung dargestellt. Die dargestellte Antenne 1 ist schneckenförmig ausgebildet, wodurch eine sehr dichte Leiterbahnenstruktur erreicht ist, die dazu führt, dass ein Angriff im Bereich der schneckenförmigen Antenne 1 zu einem Kurzschluss benachbarter Leiterbahnen bzw. zur Unterbrechung der Leiterbahnen führt, welche zu einem deutlich veränderten, übertragenen Schutzschaltungssignal führt. Diese deutliche Änderung wird dann in der beschriebenen Weise mittels dem Signaldetektor 4 erkannt und die integrierte Schaltung in den Sicherheitsmodus überführt.

Die flächige, schneckenförmige Ausbildung der Antenne 1 stellt sicher, dass die Schaltungsteile der integrierten Schaltung, welche unterhalb der Antenne 1 in darunterliegenden Schaltungsebenen angeordnet sind und somit durch die Antenne 1 bedeckt sind, nur durch Zerstörung oder durch Eingriff in die Antenne 1 von oben durch diese Antenne 1 angegriffen werden können. Ein solcher Angriff wird aber durch die Antenne 1 in der Funktion der Schutzschaltung erkannt und dementsprechend behandelt. Die Antenne 1 ist bevorzugt in der obersten und in der untersten Schaltungsebene der integrierten Schaltung angeordnet, wodurch einerseits ein umfassender Schutz der dazwischenliegenden Schaltungsebenen erreicht ist und zusätzlich eine ausgeprägt gute Sende- bzw. Empfangscharakteristik der Antenne für die Übertragung von Daten oder Energie erreicht ist. Um eine optimierte Sende- bzw. Empfangscharakteristik zu erreichen, wird die Antenne als Spule mit einer möglichst hohen Windungszahl ausgebildet, wodurch die übertragbare Energie erhöht werden kann. Zudem können auch kleine Signalveränderungen, welche die zu übertragenden Daten repräsentieren, empfangen und detektiert werden. Durch die Ausbildung mit der Antenne als Spule mit möglichst vielen Windungen ist auch sichergestellt, dass die Abstände zwischen den einzelnen Windungen bei der nur begrenzt zur Verfügung stehenden Gesamtfläche der Schaltungsebene der integrierten Schaltung sehr gering gewählt sind, so dass die Gefahr eines unbemerkten Angriffs auf die integrierte Schaltung durch exaktes Positionieren des Angriffspunktes zwischen zwei Leiterbahnen wesentlich erniedrigt werden kann.

## Patentansprüche

1. Integrierte Schaltung mit wenigstens einer Antenne (1) zur kontaktlosen Übertragung von Daten oder Energie, wobei die integrierte Schaltung übereinander angeordnete Schaltungsebenen aufweist, und einer Schutzschaltung, welche die integrierte Schaltung auf einen Angriff überwacht,
**dadurch gekennzeichnet, dass** die wenigstens eine Antenne (1) oberhalb und/oder unterhalb von zu schützenden Schaltungsteilen angeordnet ist und dass sie zusätzlich mit der Schutzschaltung verbunden oder verbindbar ist.

2. Integrierte Schaltung nach Anspruch 1,
**dadurch gekennzeichnet, dass** die Schaltung Selektionsmittel (2) aufweist, die der wenigstens einen Antenne (1) zugeordnet sind und die die Funktion der Antenne (1) als Teil der Schutzschaltung und als Mittel zur Übertragung von Daten oder Energie festlegen.

3. Integrierte Schaltung nach Anspruch 2,
**dadurch gekennzeichnet, dass** die Selektionsmittel (2) geeignet sind, die Funktion der Antenne (1) zeitlich alternierend festzulegen.

4. Integrierte Schaltung nach Anspruch 2,
**dadurch gekennzeichnet, dass** die Selektionsmittel (2) geeignet sind, Signale an die Antenne (1) zu geben und von dieser zu erhalten, die voneinander trennbare Schutzschaltungssignale und Sende- und/oder Empfangssignale enthalten.

5. Integrierte Schaltung nach Anspruch 4,
**dadurch gekennzeichnet, dass** die Selektionsmittel (2) Filter oder Demodulatoren zur Trennung der Schutzschaltungssignale und der Sende- und/oder Empfangssignale enthalten.

6. Integrierte Schaltung nach einem der vorstehenden Ansprüche,
**dadurch gekennzeichnet, dass** die wenigstens eine Antenne (1) die zu schützenden Schaltungsteile zumindest weitgehend bedeckt.

7. Integrierte Schaltung nach einem der vorstehenden Ansprüche,
**dadurch gekennzeichnet, dass** die wenigstens eine Antenne die zu schützenden Schaltungsteile sandwichartig von oben und unten zumindest weitgehend bedeckt.

8. Integrierte Schaltung nach einem der vorstehenden Ansprüche,
**dadurch gekennzeichnet, dass** die wenigstens eine Antenne (1) schneckenförmig in einer Schaltungsebene ausgebildet ist.

9. Integrierte Schaltung nach einem der vorstehenden Ansprüche,
**dadurch gekennzeichnet, dass** wenigstens ein Signalgenerator (3) zur Erzeugung eines Schutzschaltungssignals und ein Signaldetektor (4) zur Auswertung des von der Antenne zugeführten Schutzschaltungssignals vorgesehen sind, welche von der Antenne (1) zumindest weitgehend bedeckt sind.

## Claims

1. Integrated circuit with at least one antenna (1) for the contactless transmission of data or energy, the integrated circuit having circuit planes arranged one above the other, and a protective circuit which monitors the integrated circuit with regard to an attack,
**characterized in that** the at least one antenna (1) is arranged above and/or below circuit sections to be protected, and **in that** it is additionally connected or can be connected to a protective circuit.

2. Integrated circuit according to Claim 1,
**characterized in that** the circuit has selection means (2), which are assigned to the at least one antenna (1) and define the function of the antenna (1) as part of the protective circuit and as means for transmitting data or energy.

3. Integrated circuit according to Claim 2,
**characterized in that** the selection means (2) are suitable for defining the function of the antenna (1) in a temporally alternating manner.

4. Integrated circuit according to Claim 2,
**characterized in that** the selection means (2) are suitable for outputting signals to the antenna (1) and for obtaining signals from said antenna, which contain protective circuit signals and transmission and/or reception signals which can be separated from one another.

5. Integrated Circuit according to Claim 4,
**characterized in that** the selection means (2) contain filters or demodulators for separating the protective circuit signals and the transmission and/or reception signals.

6. Integrated circuit according to one of the preceding claims,
**characterized in that** the at least one antenna (1) at least largely covers the circuit sections to be protected.

7. Integrated circuit according to one of the preceding claims,
**characterized in that** the at least one antenna at least largely covers the circuit sections to be protected from above and below in a sandwich-like manner.

8. Integrated circuit according to one of the preceding claims,
**characterized in that** the at least one antenna (1) is of helical design in a circuit plane.

9. Integrated circuit according to one of the preceding claims,
**characterized in that** at least one signal generator (3) for generating a protective circuit signal and a signal detector (4) for evaluating the protective circuit signal fed from the antenna are provided, which are at least largely covered by the antenna (1).

## Revendications

1. Circuit intégré ayant au moins une antenne (1) de transmission sans contact de données ou d'énergie, le circuit intégré comprenant des plans de circuit superposés et un circuit de protection qui surveille une intervention sur le circuit intégré,
**caractérisé en ce que** la au moins une antenne (1) est placée au-dessus et/ou en dessous des parties du circuit à protéger et **en ce qu'**elle est reliée ou peut être reliée en outre au circuit de protection.

2. Circuit intégré suivant la revendication, **caractérisé en ce que** le circuit a des moyens (2) de sélection qui sont associés à la au moins une antenne (1) et qui déterminent la fonction de l'antenne (1) en tant que partie du circuit de protection et en tant que moyen de transmission de données ou d'énergie.

3. Circuit intégré suivant la revendication 2, **caractérisé en ce que** les moyens (2) de sélection sont appropriés à déterminer, en alternance dans le temps, la fonction de l'antenne (1).

4. Circuit intégré suivant la revendication 2, **caractérisé en ce que** les moyens (2) de sélection sont appropriés pour envoyer à l'antenne (1) et pour en recevoir des signaux qui comprennent des signaux du circuit de protection et des signaux d'émission et/ou de réception qui peuvent être séparés les uns des autres.

5. Circuit intégré suivant la revendication 4, **caractérisé en ce que** les moyens (2) de sélection comportent des filtres ou des démodulateurs de séparation des signaux du circuit de protection et des signaux d'émission et/ou de réception.

6. Circuit intégré suivant l'une des revendications précédentes, **caractérisé en ce que** la au moins une antenne (1) recouvre au moins dans une grande mesure les parties du circuit à protéger.

7. Circuit intégré suivant l'une des revendications précédentes, **caractérisé en ce que** la au moins une antenne recouvre au moins dans une grande mesure, par le haut et par le bas à la manière d'un sandwich, les parties du circuit à protéger.

8. Circuit intégré suivant l'une des revendications précédentes, **caractérisé en ce que** la au moins une antenne (1) est constituée en forme de colimaçon dans un plan du circuit.

9. Circuit intégré suivant l'une des revendications précédentes, **caractérisé en ce qu'**il est prévu au moins un générateur (3) de signal de production d'un signal du circuit de protection et un détecteur (4) de signal d'exploitation du signal du circuit de protection envoyé par l'antenne qui sont recouverts au moins dans une grande mesure par l'antenne (1).
